(19) Europäisches Patentamt
European Patent Office
Office européen des brevets

(11) **EP 3 736 359 B1**

(12) **FASCICULE DE BREVET EUROPEEN**

(45) Date de publication et mention de la délivrance du brevet:
**10.07.2024 Bulletin 2024/28**

(21) Numéro de dépôt: **20173569.3**

(22) Date de dépôt: **07.05.2020**

(51) Classification Internationale des Brevets (IPC):
**C30B 29/28** (2006.01)   **G06N 10/00** (2022.01)

(52) Classification Coopérative des Brevets (CPC):
**G06N 10/00; C30B 29/28**

(54) **MATÉRIAU AMÉLIORE POUR LE TRAITEMENT SPECTRO-SPATIAL DE SIGNAUX OPTIQUES**

VERBESSERTES MATERIAL FÜR DIE SPEKTRAL-RÄUMLICHE VERARBEITUNG VON OPTISCHEN SIGNALEN

IMPROVED MATERIAL FOR SPECTRO-SPATIAL PROCESSING OF OPTICAL SIGNALS.

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.05.2019 FR 1904804**

(43) Date de publication de la demande:
**11.11.2020 Bulletin 2020/46**

(73) Titulaires:
• **THALES**
  **92400 Courbevoie (FR)**
• **SORBONNE UNIVERSITE**
  **75006 Paris (FR)**
• **Université Paris-Sud 11**
  **91405 Orsay Cedex (FR)**
• **Centre National de la Recherche Scientifique**
  **75016 Paris (FR)**
• **ECOLE NATIONALE SUPERIEURE DE CHIMIE DE PARIS**
  **75231 Paris Cedex 05 (FR)**
• **École Normale Supérieure Paris-Saclay**
  **94235 Cachan (FR)**

(72) Inventeurs:
• **FERRIER, Alban**
  **75252 PARIS CEDEX 05 (FR)**
• **CHAUVET, Anne**
  **91190 GIF SUR YVETTE (FR)**
• **GOLDNER, Philippe**
  **75016 PARIS (FR)**
• **BERGER, Perrine**
  **91400 PALAISEAU (FR)**
• **MORVAN, Loïc**
  **91400 PALAISEAU (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**US-B1- 8 829 471**

• **FERRIER ALBAN ET AL: "Scandium doped Tm:YAG ceramics and single crystals: Coherent and high resolution spectroscopy", JOURNAL OF LUMINESCENCE, vol. 194, 29 September 2017 (2017-09-29) - 29 September 2017 (2017-09-29), pages 116 - 122, XP085262970, ISSN: 0022-2313, DOI: 10.1016/J.JLUMIN.2017.09.056**

**Description**

DOMAINE DE L'INVENTION

L'invention concerne le domaine du traitement spectro-spatial de signaux optiques, reconfigurable et/ou large bande, et plus particulièrement sur la mise en oeuvre d'architectures de traitement basées sur le creusement spectral (« spectral hole burning » ou SHB en anglais) réalisé dans un milieu atomique à élargissement inhomogène.

ETAT DE LA TECHNIQUE

Les méthodes de creusement spectral s'appliquent au traitement de signaux optiques, tels que l'analyse spectrale, le filtrage, la corrélation, et plus particulièrement au traitement de signaux radar (fréquence RF) portés optiquement. D'autres applications nécessitant également un traitement spectro-spatial sont par exemple l'imagerie acousto-optique, la stabilisation laser, la détection de motifs numériques en communication RF ou large bande.

Le principe de traitement/d'analyse spectrale d'un signal par creusement spectral (SHB) décliné selon deux types d'architecture, est rappelé ci-dessous.

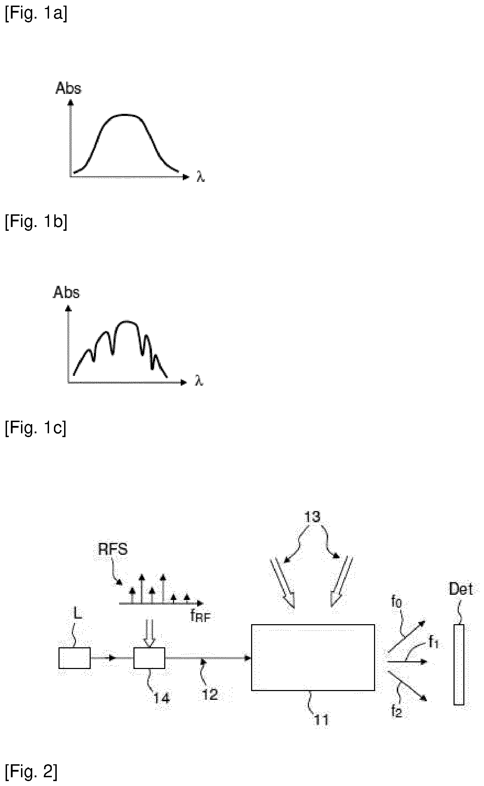

Un premier type d'architecture, basé sur le SHB par inscription d'une fonction de traitement dans un cristal 11, est illustré figure 1. La figure 1a illustre l'absorption Abs du cristal 11 en fonction de la longueur d'onde λ avant la programmation par SHB et la figure 1b illustre cette même absorption après la programmation par SHB. La mise en oeuvre du SHB s'effectue avec un cristal à très basse température, ce dernier devant présenter un élargissement inhomogène de sa transition optique à ces températures.

Le principe de l'architecture est illustré figure 1c. L'objectif est de traiter des signaux optiques, par exemple des signaux RF inconnus RFS présentant une structure fréquentielle complexe et portés optiquement : le signal RFS est appliqué à une porteuse optique générée par un laser L via un modulateur 14 pour former un faisceau 12. Le faisceau 12, constitué d'une porteuse optique modulée par le signal RF d'intérêt, est incident sur le cristal 11 dont l'absorption est « programmée » par inscription d'une fonction de traitement tel qu'illustré figure 1c.

La programmation par SHB est réalisée par un ou plusieurs faisceaux optiques 13 qui illuminent le cristal 11. Ces faisceaux permettent de façonner l'absorption du cristal 11 de manière à réaliser une fonction de programmation prédéterminée par creusement de l'absorption de 11, tel qu'illustré figure 1b.

Un exemple d'application de ce premier type d'architecture est l'analyse spectrale dite « arc en ciel».

Une fonction de dispersion angulaire est programmée dans le cristal, comme illustré figure 1c: on associe à chaque fenêtre fréquentielle de transmission un angle, et le faisceau 12 incident se diffracte sur le cristal 11 réalisant une dispersion angulaire de la fréquence. Le ou les faisceaux transmis par le cristal 11 sont ensuite analysés via un détecteur Det de manière à extraire l'information souhaitée sur le signal RFS.

Lors de la programmation d'une fonction de filtrage, seule une bande de fréquence prédéfinie du faisceau 12 est transmise par le cristal.

Les faisceaux optiques 13 sont configurés pour exciter périodiquement le cristal de manière à entretenir le profil d'absorption, jusqu'à l'établissement d'un régime stationnaire. Une fois le régime stationnaire atteint l'analyse peut être effectuée pendant 100% du temps.

Un deuxième type d'architecture basé sur le SHB par enregistrement dans le cristal du signal à caractériser, est illustré figure 2. Ici le faisceau 12 inscrit directement son spectre dans l'absorption du cristal 11 en creusant localement l'absorption pour chacune de ses fréquences. Un exemple d'application de ce deuxième type d'architecture est l'analyse spectrale dite « photographique».

Un faisceau de lecture 15 traverse le cristal programmé 11 et est ensuite détecté par un détecteur Det. Ce faisceau de lecture est balayé spectralement, et vient relire le spectre enregistré dans l'absorption du matériau.

Le SHB permet ainsi le traitement analogique de signaux radiofréquence grâce à la programmation de fonctions de traitement spectro-spatial dans le spectre d'absorption d'un processeur atomique.

Les architectures de traitement par SHB présentent l'intérêt d'être reconfigurables, c'est-à-dire de pouvoir être utilisées pour plusieurs fonctions. Par exemple, dans le cas d'un analyseur spectral, il peut être pertinent de reconfigurer le filtre afin de réduire ou augmenter la bande d'analyse en fonction des besoins. Il est également nécessaire d'être en mesure de reprogrammer rapidement le filtre lorsque celui-ci a été accidentellement dégradé. La vitesse de reconfiguration est alors un paramètre crucial pour minimiser les temps morts du dispositif.

Les matériaux employés pour ces architectures, appelés « processeurs atomiques », sont généralement des cristaux dopés avec des ions terre rare refroidis en dessous de 5K. Le processeur atomique le plus utilisé actuellement est le cristal de grenat d'aluminium et d'yttrium dopé avec du thulium, noté $Tm^{3+}$ :$Y_gAl_5O_{12}$, symbolisé par Tm:YAG. Le creusement spectral s'effectue en modifiant la répartition des populations atomiques des différents niveaux d'énergie intervenant dans le processus.

Une des limites du premier type d'architecture est la vitesse de reconfiguration de la fonction de traitement et la vitesse d'initialisation. Une des limites du deuxième type d'architecture est la résolution temporelle de l'enregistrement.

Ces limites trouvent leur source dans la valeur du temps de vie des excitations atomiques dans le matériau, comme expliqué ci-dessous.

De manière plus générale les propriétés spectroscopiques intrinsèques du matériau conditionnent une part importante des performances des architectures de SHB.

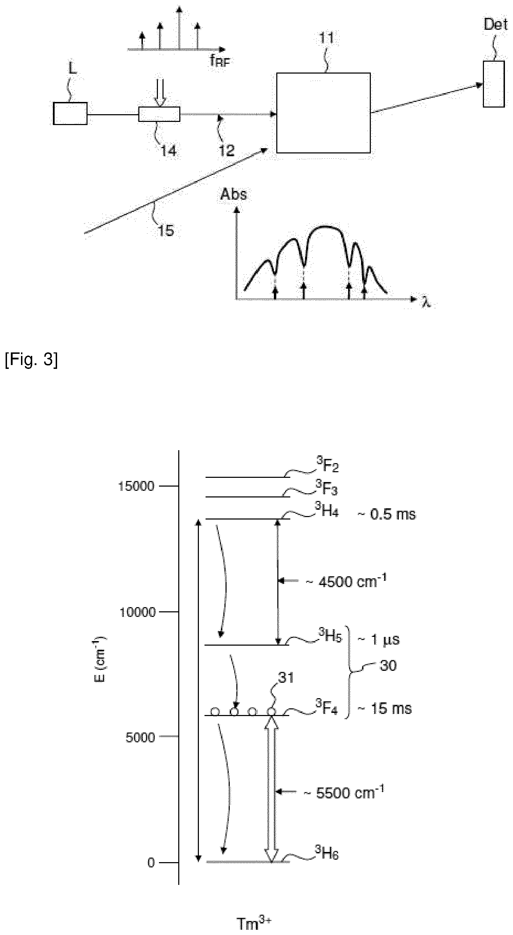

La figure 3 illustre la structure électronique de l'ion thulium $Tm^{3+}$, ion optiquement actif du cristal, dans une matrice YAG, c'est-à-dire la répartition des niveaux d'énergie de l'ion thulium $Tm^{3+}$ et les temps de vie associés à chaque niveau.

Le niveau $^3H_6$ est dénommé niveau fondamental, le niveau $^3H_4$ est dénommé niveau de pompage. Le creusement spectral s'effectue par excitation du niveau $^3H_4$ de pompage via la ou les ondes optiques présentant la longueur d'onde adaptée à la transition $^3H_6 \rightarrow {}^3H_4$, proche de 793 nm.

Les niveaux intermédiaires $^3H_5$ et $^3F_4$ sont liés entre eux et peuvent être traités simultanément comme un seul niveau métastable 30.

Les temps de vie des niveaux sont, pour un dopage de Tm de 0.5%, de l'ordre de :

$^3H_4$ : 0.5 ms; $^3H_5$ : 1 $\mu$s ; $^3F_4$ : 15 ms,

Le processus de pompage optique est un processus séquentiel. Les atomes sont tout d'abord excités par un laser résonnant avec le niveau de pompage $^3H_4$. Une partie de la population des ions $Tm^{3+}$ est donc transférée vers ce niveau $^3H_4$. Dans un second temps les ions vont retourner vers l'état fondamental soit directement de manière radiative vers le niveau fondamental soit en passant par le niveau métastable $^3H_5$ et $^3F_4$ où ils vont être stockés avant de relaxer vers le niveau fondamental. Pour être efficace le pompage optique doit être répété un grand nombre de fois.

Les différences d'énergie typiques des transitions électroniques du $Tm^{3+}$ sont comprises entre 14000 et 2000 $cm^{-1}$. Par exemple la différence d'énergie entre les niveaux $^3H_4$ et $^3H_5$ du $Tm^{3+}$ est d'environ 4500 $cm^{-1}$ et la différence d'énergie entre les niveaux $^3F_4$ et $^3H_6$ du $Tm^{3+}$ est d'environ 5500 $cm^{-1}$.

Les valeurs des temps de vie des différents niveaux du thulium conditionnent l'efficacité de la programmation, c'est-à-dire imposent une limite à la vitesse de reconfiguration (ou à la résolution temporelle en fonction de l'architecture) et, dans une moindre mesure, imposent une limite sur le contraste des structures programmées et donc la dynamique d'analyse. Ces valeurs impactent également l'efficacité de pompage optique.

En effet, l'initialisation du matériau se fait par la répétition d'impulsions lumineuses successives qui aboutiront in fine à une répartition contrôlée des populations dans les différents niveaux (voir figure 3). Au cours de ce processus, une fraction 31 de la population est stockée dans les états $^3H_5$ et surtout $^3F_4$ d'énergie intermédiaire (niveau métastable). Cette population n'est alors plus disponible et ne participe pas à l'étape d'initialisation. La durée de vie du niveau métastable 30 est typiquement de l'ordre de 15 ms, alors que celle du niveau excité $^3H_4$ est de 0.5 ms : du fait de la présence du niveau $^3F_4$ présentant un long temps de vie, on observe un goulot d'étranglement («bottleneck» en anglais) sur ce niveau, qui diminue la vitesse d'initialisation et de reconfigurabilité (ou la résolution temporelle selon les architectures), et l'efficacité de pompage optique.

Le caractère inhomogène de la raie d'absorption $\Delta\Gamma_{inh}$ de la transition entre les niveaux $^3H_6 \rightarrow {}^3H_4$ (pompage) provient du fait que la matrice de YAG possède des défauts et n'est pas parfaitement périodique. Du fait de ce désordre chacun des ions thulium voit ainsi un environnement local légèrement spécifique et différent de celui des autres, ce qui crée un élargissement inhomogène de la fréquence de la raie à 793 nm de 20 GHz, pour un échantillon dopé à 0.5% en $Tm^{3+}$.

Cette largeur inhomogène de la raie d'absorption $\Delta\Gamma_{inh}$ entre les niveaux $^3H_6 \rightarrow {}^3H_4$ à 793 nm conditionne la bande passante d'analyse, c'est-à-dire la bande passante instantanée de traitement, qui est ainsi limitée à environ 20 GHz.

Ainsi, dans le YAG dopé thulium Tm : YAG, les propriétés intrinsèques de la transition à 793 nm induisent un temps de vie des structures inscrites optiquement dans le matériau de l'ordre de 15 millisecondes sans champ magnétique, et une bande passante d'analyse de l'ordre de 15 à 20 GHz.

Pour des applications de traitement ou d'analyse spectrale de signaux radar large bande (après transposition dans le domaine optique), ou d'analyse de signaux numériques très grand débit, il est souhaitable :

- de pouvoir reconfigurer la fonction de traitement en un temps inférieur à la milliseconde (contre 15 ms pour le Tm :YAG),
- d'améliorer la résolution temporelle de l'enregistrement, à mieux que la milliseconde (limitée à 15 ms pour le Tm :YAG),
- d'augmenter la bande passante de traitement à 40 GHz voire au-delà (contre 20 GHz pour le Tm:YAG), compte tenu de l'augmentation continue en fréquence des bandes d'intérêt du spectre électromagnétique, et du débit de plus en plus élevé des communications numériques.

Le problème du temps de vie est adressé dans l'état de l'art :

- en utilisant une excitation lumineuse intense pour « effacer » la fonction ou le signal inscrit, avec l'inconvénient que les puissances nécessaires à un effacement rapide sont en général élevées, et donc contraignantes sur la technologie de la source optique ainsi que sur la cryogénie (la température usuelle d'utilisation de ces matériaux étant de quelques Kelvins),

- en augmentant le taux de dopage du matériau, ce qui réduit les temps de vie des populations des niveaux métastable et excité par le biais de la relaxation croisée. Ce phénomène se produit lorsqu'un ion possède trois niveaux d'énergie tels que leurs écarts sont presque égaux. L'échange d'énergie qui a lieu entre un ion dans son état fondamental et un deuxième ion dans son état excité provoque l'excitation du premier et la désexcitation du second, de sorte qu'ils se retrouvent dans le niveau intermédiaire. Cela se produit par exemple dans le Tm:YAG pour des taux de dopage supérieurs à 2%, tel que décrit dans la publication de G. Armagan et al., Optical Materials 1, pp11-20 (1992). Cela entraîne toutefois une augmentation de la largeur homogène du Tm, ce qui dégrade la résolution spectrale du dispositif.

Pour augmenter la bande passante de traitement, c'est-à-dire la largeur inhomogène $\Delta\Gamma_{inh}$ du Tm :YAG, une solution est d'introduire une autre terre rare dans la matrice de YAG. Ce composé se substitue partiellement à l'ion yttrium et crée autour de lui des contraintes mécaniques qui modifient de manière permanente la structure cristalline et donc l'environnement des ions Tm. Le document US8829471 décrit l'utilisation d'une matrice de YAG modifiée avec du lutécium, de formule Tm :YLuAG ou plus précisément :

$Tm^{3+}:Y_{3-x}LU_xAl_5O_{12}$, avec x désignant le nombre moyen d'atomes de lutécium dans une molécule de la matrice modifiée et x compris entre 0.1 et 2.9. La publication de A. Ferrier et al, J.Lumin. 194, p116-122 (2018) décrit l'utilisation du Scandium.

Cependant aucun de ces cristaux ne modifie significativement les valeurs des temps de vie des niveaux de l'ion thulium, et les limitations liées à ces valeurs demeurent.

Un but de la présente invention est de remédier aux inconvénients précités en proposant un nouveau matériau, ainsi que son utilisation dans un dispositif de creusement spectral (SHB), présentant à la fois des temps de vie réduits et une largeur spectrale inhomogène augmentée.

## DESCRIPTION DE L'INVENTION

La présente invention a pour objet un cristal pour une utilisation dans un dispositif de traitement spectro-spatial de signaux optique par creusement spectral, de formule chimique $Y_{3(1-x-y)}Tm_{3y}M_{3x}Al_5O_{12}$ avec M représentant un cation trivalent noté $M^{3+}$ différent du thulium et choisi de sorte qu'il substitue une partie des cations trivalents yttrium notés $Y^{3+}$, x représentant le taux de substitution dudit cation $M^{3+}$, et y représentant le taux de substitution du cation trivalent thulium noté $Tm^{3+}$. Le cation $M^{3+}$ appartient à la famille des Lanthanides ou à la famille des Métaux de transition, le cation $Tm^{3+}$ présente une structure électronique comprenant un niveau fondamental, un niveau de pompage, un niveau intermédiaire métastable et une première transition entre le niveau métastable et le niveau fondamental, le cation $M^{3+}$ présente une structure électronique comprenant une première transition résonnante avec ladite première transition du cation $Tm^{3+}$.

Selon un mode de réalisation le niveau métastable du cation $Tm^{3+}$ comprend un niveau dénommé $^3H_5$ et un niveau dénommé $^3F_4$, et la première transition du cation $M^{3+}$ est résonnante avec la première transition du cation $Tm^{3+}$ définie comme la transition entre le niveau $^3F_4$ et le niveau fondamental.

Selon un mode de réalisation le cation $Tm^{3+}$ présente une deuxième transition entre le niveau de pompage et le niveau métastable et dans lequel le cation $M^{3+}$ présente une structure électronique comprenant en outre une deuxième transition résonnante avec ladite deuxième transition du cation $Tm^{3+}$.

Préférentiellement la première et le cas échéant la deuxième transition du cation $M^{3+}$ présentent une différence d'énergie avec respectivement la première et le cas échéant la deuxième transition du cation $Tm^{3+}$ d'au maximum 1500 cm$^{-1}$.

Préférentiellement x est compris entre 0.05 et 0.9.

Préférentiellement y est compris entre 0.001 et 0.05.

Selon un mode de réalisation le cation $M^{3+}$ est choisi parmi : l'Europium, le Terbium.

Selon un autre aspect l'invention concerne un dispositif de traitement spectro-spatial de signaux optique par creusement spectral comprenant :

- une source laser émettant un faisceau optique,
- un dispositif de modulation configuré pour moduler le faisceau optique avec un signal à analyser,
- un cristal selon l'invention disposé dans un cryostat à une température inférieure à 5K, configuré pour être illuminé par ledit faisceau optique modulé,
- un détecteur configuré pour détecter au moins une fraction d'un faisceau optique issu du cristal.

Selon un autre aspect l'invention concerne un procédé de traitement spectro-spatial de signaux optique par creusement spectral comprenant les étapes consistant à :

- émettre un faisceau optique,
- moduler ledit faisceau optique par un signal à analyser,
- illuminer un cristal disposé dans un cryostat à une température inférieure à 5K par ledit faisceau optique modulé,
- réaliser un creusement spectral dans ledit cristal,
- détecter au moins une fraction d'un faisceau optique issu du cristal.

Le cristal présente la formule chimique $Y_{3(1-x-y)}Tm_{3y}M_{3x}Al_5O_{12}$ avec M représentant un cation trivalent noté $M^{3+}$ différent du thulium et choisi de sorte qu'il substitue une partie des cations trivalents yttrium notés $Y^{3+}$, x représentant le taux de substitution dudit cation $M^{3+}$, et y représentant le taux de substitution du cation trivalent thulium noté $Tm^{3+}$. Le cation $M^{3+}$ appartient à la famille des Lanthanides ou à la famille des métaux de transition. Le cation $Tm^{3+}$ présente une structure électronique comprenant un niveau fondamental, un niveau de pompage un niveau intermédiaire métastable et une première transition entre le niveau métastable et le niveau fondamental. Le cation $M^{3+}$ présente une structure électronique comprenant une première transition résonnante avec ladite première transition du cation $Tm^{3+}$.

La description suivante présente plusieurs exemples de réalisation du dispositif de l'invention : ces exemples sont non limitatifs de la portée de l'invention. Ces exemples de réalisation présentent à la fois les caractéristiques essentielles de l'invention ainsi que des caractéristiques additionnelles liées aux modes de réalisation considérés. Par souci de clarté les mêmes éléments porteront les mêmes repères dans les différentes figures.

L'invention sera mieux comprise et d'autres caractéristiques, buts et avantages de celle-ci apparaîtront au cours de la description détaillée qui va suivre et en regard des dessins annexés donnés à titre d'exemples non limitatifs et sur lesquels :

[Fig 1a] La figure 1a illustre, pour une première architecture de traitement spectro-spatial par creusement spectral, l'absorption du cristal en fonction de la longueur d'onde avant la programmation.

[Fig 1b] La figure 1b illustre cette même absorption du cristal en fonction de la longueur d'onde après la programmation.

[Fig 1c] La figure 1c illustre le faisceau constitué d'une porteuse optique modulée par le signal RF d'intérêt, incident sur le cristal dont l'absorption est « programmée » par inscription d'une fonction de traitement, ainsi la fonction de dispersion angulaire issue de la programmation du cristal.

[Fig 2] La figure 2 déjà citée illustre un deuxième type d'architecture de traitement spectro-spatial par creusement spectral par enregistrement dans le cristal du signal à caractériser.

[Fig 3] La figure 3 déjà citée illustre la structure électronique de l'ion thulium $Tm^{3+}$.

[Fig 4] La figure 4 illustre le mécanisme physique mis en oeuvre dans le cristal selon l'invention.

[Fig 5] La figure 5 illustre à titre d'exemple de cristal selon l'invention les niveaux électroniques du cation $Eu^{3+}$ en regard des niveaux du thulium.

## DESCRIPTION DETAILLEE DE L'INVENTION

L'objectif de l'invention est de réaliser un nouveau cristal optimisé pour des applications de traitement spectro-spatial de signaux optiques (signaux analogiques ou numériques sur porteuse optique) avec des bandes d'analyse comprises typiquement entre 20 GHz et 200 GHz.

Selon un premier aspect l'invention concerne un cristal CR pour une utilisation dans un dispositif de traitement spectro-spatial de signaux optiques par creusement spectral. La formule chimique du cristal selon l'invention est $Y_{3(1-x-y)}Tm_{3y}M_{3x}Al_5O_{12}$ , avec M représentant un cation trivalent noté $M^{3+}$ différent du thulium choisi de sorte qu'il substitue une partie des cations trivalents yttrium notés $Y^{3+}$, x représentant le taux de substitution dudit cation $M^{3+}$, et y représentant le taux de substitution du cation trivalent thulium noté $Tm^{3+}$.

Ainsi dans la matrice du cristal selon l'invention une fraction des cations yttrium sont substitués par des cations thulium (taux y pouvant s'exprimer en %) et une autre fraction des ions yttrium sont substitués par des cations $M^{3+}$ (taux x).

Le cation $M^{3+}$ appartient à la famille des Lanthanides ou à la famille des Métaux de transition. Le cristal CR selon l'invention dérive de la structure grenat, et la présence du cation $M^{3+}$ dans la matrice du cristal selon l'invention permet d'obtenir un matériau aux propriétés améliorées pour des applications de SHB, comme expliqué plus loin.

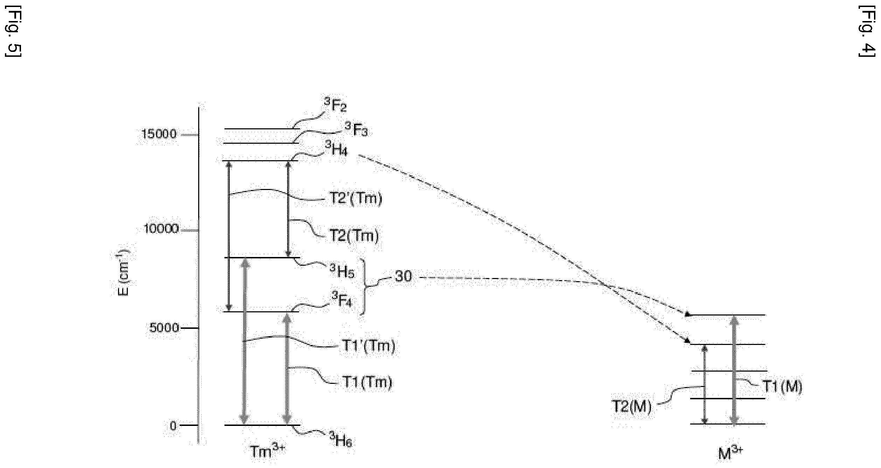

Le mécanisme physique découvert par les inventeurs et mis en oeuvre dans le cristal selon l'invention est illustré figure 4.

Comme décrit plus haut le cation $Tm^{3+}$ présente une structure électronique comprenant un niveau fondamental $^3H_6$, un niveau de pompage $^3H_4$ et un niveau intermédiaire métastable 30. On définit une première transition entre le niveau métastable 30 et le niveau fondamental illustrée figure 4. Le niveau métastable 30 comprenant deux niveaux $^3H_5$ et $^3F_4$, cette première transition correspond soit à la transition $^3F_4 \rightarrow \, ^3H_6$ que nous dénommerons T1 (Tm) soit à la transition $^3H_5 \rightarrow \, ^3H_6$ que nous dénommerons T1'(Tm).

Le cation $M^{3+}$ selon l'invention, dont la structure électronique est également illustrée figure 4, est choisi de manière à présenter une structure électronique comprenant au moins une transition, dénommée première transition T1(M), résonnante avec la première transition du cation $Tm^{3+}$, qui peut être T1 (Tm) ou T1'(Tm). Cette première transition T1(M) est entre un niveau « excité » et le niveau fondamental.

Cette résonance entre les structures électroniques du $Tm^{3+}$ et du $M^{3+}$ permet des transferts d'énergie entre les deux cations. On entend par niveau résonnant un niveau dont l'énergie est proche de celle libérée par l'ion actif (ici le thulium) lors de l'étape de relaxation que l'on souhaite raccourcir. Ainsi, l'énergie libérée-lors de la relaxation de l'ion actif $Tm^{3+}$ est transférée au cation $M^{3+}$ et porte celui-ci dans un état excité. Ce transfert d'énergie s'effectue par un couplage électrostatique (dipôle -dipôle, dipôle-quadrupôle) entre l'ion Tm et l'ion M. Si ce mécanisme est résonnant et que la distance entre les ions Tm et M est optimisée il peut s'avérer bien plus rapide que la relaxation radiative.

En effet, un tel transfert d'énergie, faisant en particulier intervenir T1(Tm), a pour effet d'accélérer la relaxation de l'ion actif $Tm^{3+}$ et donc de diminuer considérablement le temps de vie du niveau $^3F_4$.

Cette diminution du temps de vie du niveau $^3F_4$ améliore la vitesse d'initialisation et de reconfigurabilité (ou de résolution temporelle), ainsi que l'efficacité du pompage optique d'un dispositif de SHB basé sur le cristal selon l'invention.

D'autre part les cations substitués $M^{3+}$ présentent un rayon ionique différent mais proche de celui de l'yttrium, de manière à être compatible avec la substitution des cations $Y^{3+}$. Cette différence de rayon ionique va entraîner l'apparition d'un désordre statistique supplémentaire au sein de la structure cristalline ce qui va entraîner une augmentation de la largeur inhomogène. Cette augmentation de la largeur inhomogène permet l'augmentation de la bande passante de l'analyseur de spectre. Préférentiellement le cation $M^{3+}$ présente un rayon ionique $R_M$ différent du rayon ionique de l'yttrium $R_Y$ d'au maximum +/-20%, avec $R_Y$ = 1.019 Å.

A noter que le lutétium et le scandium, substituants de l'yttrium connus de l'état de la technique, ne présentent pas une structure électronique résonnante avec l'ion thulium. Ils ont été choisis uniquement pour leur compatibilité avec la matrice grenat et pour l'introduction de désordre tel qu'expliqué ci-dessus, pour élargir la largeur inhomogène de la transition de pompage.

Pour une diminution optimale du temps de vie de l'un des niveaux métastables, selon un mode de réalisation préféré la première transition T1(M) du cation $M^{3+}$ est résonnante avec la première transition du cation $Tm^{3+}$ , T1(M) étant définie comme la transition entre l'un des niveaux métastables et le niveau fondamental $^3H_6$. En effet l'essentiel de la population étant stocké dans le niveau métastable, il est préférable de raccourcir en priorité la durée de vie de ce niveau.

Une autre façon de diminuer la population stockée dans le niveau métastable est d'effectuer un transfert d'énergie mettant en jeu la transition T1' définie comme la transition entre le niveau $^3H_5$ et le niveau fondamental $^3H_6$. Cependant il faut que ce transfert soit suffisamment efficace pour intervenir avant la relaxation de la population du niveau $^3H_5$ vers le niveau $^3F_4$ sachant que cette relaxation s'effectue en quelques $\mu$s.

Une fois le temps de vie du niveau $^3F_4$ nettement diminué, d'autres temps de vie tels que celui sur le niveau de pompage $^3H_4$ deviennent limitants pour le dispositif de SHB.

Comme illustré figure 4 le cation $Tm^{3+}$ présente une deuxième transition entre le niveau de pompage $^3H_4$ et le niveau métastable 30. Cette deuxième transition correspond soit à la transition $^3H_4 \rightarrow \, ^3H_5$ que nous dénommerons T2(Tm) soit à la transition $^3H_4 \rightarrow \, ^3F_4$ que nous dénommerons T2'(Tm).

Selon une variante le cation $M^{3+}$ présente une structure électronique comprenant en outre une deuxième transition T2(M) résonnante avec la deuxième transition du cation $Tm^{3+}$, T2(Tm) ou T2'(Tm). Le transfert d'énergie mis en oeuvre ici est un mécanisme similaire à celui présenté précédemment. Pour être efficace il nécessite également une résonnance en énergie.

Pour un transfert d'énergie optimum, préférentiellement la première transition T1 (M) présente une différence d'énergie avec la première transition du cation $Tm^{3+}$ (T1 (Tm) ou T1'(Tm)) sensiblement égale à +/- 1500 cm$^{-1}$.

De même le cas échéant préférentiellement la deuxième transition T2(M) présente une différence d'énergie avec la deuxième transition du cation $Tm^{3+}$ (T2(Tm) ou T2'(Tm)) d'au maximum 1500 cm$^{-1}$. Pour être efficace ces transferts d'énergies doivent être résonnants, c'est-à-dire que la différence d'énergie entre les niveaux de l'ion Tm doit être environ égale à la différence d'énergie entre les niveaux M. En effet ce transfert est d'autant plus efficace lorsqu'il est élastique c'est-à-dire que l'énergie est conservée.

A noter que lorsqu'une différence d'énergie est présente elle peut être compensée par l'émission ou l'absorption de phonon. Cependant on observe alors une diminution importante de l'efficacité du transfert.

Au niveau des taux de substitution préférentiellement le taux y de substitution de thulium est compris entre 0.001 (0.1%) et 0.05 (5%). Le taux choisi est en relation avec les performances souhaitées du dispositif de SHB utilisant le cristal selon l'invention.

Une valeur de 0.5 % est standard dans les cristaux de grenat dopé thulium selon l'état de la technique. On utilise le terme de dopage lorsque le taux de substitution est faible (<10%).

La valeur du taux x est préférentiellement comprise entre 0.05 et 0.9. Le choix de sa valeur est également fonction des performances souhaitées du dispositif de SHB utilisant le cristal selon l'invention, plus particulièrement du couple rapidité/résolution souhaité de l'analyseur.

Préférentiellement le cation $M^{3+}$ est l'europium Eu ou le terbium Tb.

Les inventeurs ont en effet identifié que ces deux ions lanthanides présentent des transitions résonnantes avec l'ion thulium.

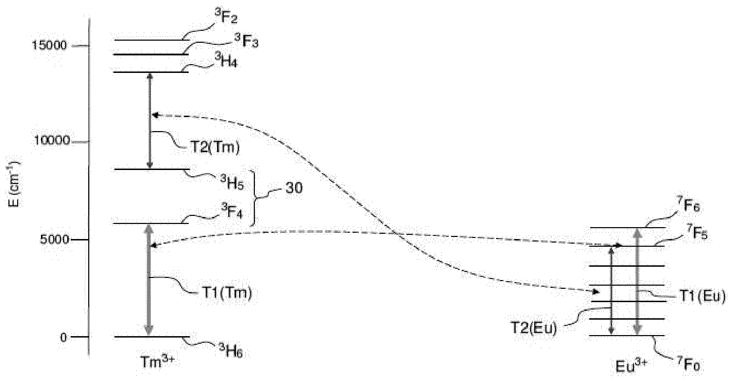

Les niveaux électroniques du cation $Eu^{3+}$ sont illustrés figure 5 en regard des niveaux du thulium précédemment décrits.

L'europium présente une première transition T1(Eu) entre le niveau $^7F_6$ et le niveau $^7F_0$ présentant une énergie d'environ 5000 cm$^{-1}$ résonnante avec la transition T1(Tm) d'énergie 5500 cm$^{-1}$. Il présente également une deuxième transition T2(Eu) entre le niveau $^7F_5$ et le niveau $^7F_0$ présentant une énergie de 4000 cm$^{-1}$ résonnante avec la transition T2(Tm) présentant une énergie d'environ 4500 cm$^{-1}$.

L'europium possède un rayon ionique égale à 1.066 Å, 5% plus grand que celui de l'yttrium.

Le tableau 1 ci-dessous illustre, pour différents cristaux de YAG réalisés avec différentes combinaisons de valeurs de x et de y exprimées en %, les valeurs mesurées, à une température de 5K, de la largeur inhomogène $\Delta\Gamma_{inh}$, du temps de vie du niveau $^3F_4$ et du temps de vie du niveau $^3H_4$ .

[Table 1]

| Taux y Tm [% at] | 0.4 | 0.5 | 0.5 | 0.5 | 0.5 | 0.5 | 0.8 |
|---|---|---|---|---|---|---|---|
| Taux x Eu [% at] | 0 | 0 | 1 | 2 | 4 | 6 | 1 |
| Largeur inhomogène $\Delta\Gamma_{inh}$ (GHz) | 18.9 | 12 | 22 | 26 | 35 | 44 | 24 |
| Temps de vie $^3F_4$ (ms) | 15 | 13 | 0.2 | 0.06 | 0.02 | 0.009 | 0.34 |
| Temps de vie $^3H_4$ (ms) | 0.6 | 0.4 | 0.4 | 0.3 | 0.1 | 0.05 | 0.3 |

On remarque à partir de ce tableau que la présence du couple thulium/europium permet de réduire significativement la durée de vie du niveau métastable grâce à la présence d'un transfert d'énergie entre les ions $Tm^{3+}$ et $Eu^{3+}$. Une diminution du temps de vie du niveau de pompage $^3H_4$ est aussi observée. Cependant en raison d'un transfert d'énergie moins efficace cette diminution s'avère plus modérée que celle observée pour le niveau $^3F_4$.

Par exemple avec 1% d'ions Eu, une diminution de la durée de vie du niveau $^3F_4$ de deux ordres de grandeur a été obtenue pour une variation minime de la durée de vie du niveau de pompage qui ne diminue que d'un tiers.

Pour un taux y de substitution plus important, le temps de vie du niveau métastable $^3F_4$ continue de chuter, tandis que celui du niveau excité $^3H_4$ chute également, mais dans une moindre mesure. A mesure que l'on augmente la concentration en ion europium on observe une diminution de la distance entre les ions europium et les ions thulium. Cette diminution de distance va entraîner une augmentation de l'efficacité des deux transferts T1 et T2.

Il a par ailleurs été vérifié que la largeur homogène de la transition $^3H_4$ et les temps de vie des niveaux Zeeman restent compatibles avec les applications envisagées.

On remarque également que la largeur inhomogène $\Delta\Gamma_{inh}$ augmente d'environ 5 GHz par % d'$Eu^{3+}$ ajouté (à % de thulium constant).

Il existe une limite au niveau du temps de vie du niveau de pompage 3H4.

La valeur limite correspond à la résolution fréquentielle souhaitée du traitement spectro-spatial. En effet si l'on suppose que les processus de décohérence restent les mêmes (ils devraient même diminuer grâce à l'élargissement de la largeur inhomogène qui diminue la résonnance entre les spins de l'aluminium) la valeur limite du temps de vie du niveau de pompage $^3H_4$ est donnée par :

[Math 1]

$$T_1 = \frac{1}{2 * \pi * \Gamma_h}$$

avec T1 représentant le temps de vie du niveau de pompage et $\Gamma_h$ correspondant à la largeur homogène qui impose la résolution fréquentielle maximale pouvant être atteinte. En effet la résolution fréquentielle maximale pouvant être atteinte correspond à 2 fois $\Gamma_h$.

Par exemple, pour une résolution souhaitée de 1 MHz la limite inférieure de temps de vie T1est de 0.4 $\mu$s, et pour une résolution souhaitée de 25 kHz la limite inférieure de temps de vie $T_1$ est de 12 $\mu$s.

Ainsi donc si l'on souhaite un dispositif rapide et peu résolu, on augmentera la valeur de y.

En fait la résolution de l'appareil est liée à la durée de vie du niveau $^3H_4$. Une durée de vie trop courte entraînerait une augmentation de la largeur homogène et donc une perte de résolution. En effet la résolution maximum accessible est égale à 2 fois la largeur homogène (voir ci-dessus).

Selon un autre aspect l'invention concerne un dispositif de traitement spectro-spatial de signaux optique par creusement spectral tel que décrit dans l'état de la technique sur les figures 1 et 2 utilisant un cristal selon l'invention. Le dispositif comprend une source laser L émettant un faisceau optique, un dispositif de modulation 14 configuré pour moduler le faisceau optique avec un signal RFS, préférentiellement RF, à analyser, le cristal CR selon l'invention disposé dans un cryostat à une température inférieure à 5K, configuré pour être illuminé par ledit faisceau optique modulé 12, et un détecteur Det configuré pour détecter au moins une fraction d'un faisceau optique issu du cristal.

La diminution très importante des temps de vie des niveaux d'intérêt permet de considérer de nouveaux protocoles de traitements spectro-spatiaux. Par exemple, avec un dispositif selon l'invention on améliore à la fois la bande passante et la reconfigurabilité d'un analyseur spectral radiofréquence basé sur la propriété de creusement spectral.

De plus le dispositif selon l'invention n'est pas limité au contexte du traitement optique de signaux hyperfréquence (analyseur de spectres, goniométrie, filtrage), mais peut être utilisé dans les autres applications nécessitant un traitement spectro-spatial de signaux optiques comme l'imagerie acousto-optique ou la stabilisation de lasers.

Selon un dernier aspect l'invention concerne un procédé de traitement spectro-spatial de signaux optique par creusement spectral comprenant les étapes consistant à :

- émettre un faisceau optique,
- moduler ledit faisceau optique par un signal à analyser,
- illuminer un cristal disposé dans un cryostat à une température inférieure à 5K par ledit faisceau optique modulé,

  - -réaliser un creusement spectral dans ledit cristal -détecter au moins une fraction d'un faisceau optique issu du cristal.

Le cristal utilisé pour la mise en oeuvre de la méthode est un cristal CR selon l'invention.

## Revendications

1. Cristal (CR) pour une utilisation dans un dispositif de traitement spectro-spatial de signaux optique par creusement spectral, de formule chimique $Y_{3(1-x-y)}$ $Tm_{3y}M_{3x}Al_sO_{12}$ avec M représentant un cation trivalent noté $M^{3+}$ différent du thulium et choisi de sorte qu'il substitue une partie des cations trivalents yttrium notés $Y^{3+}$, x représentant le taux de substitution dudit cation $M^{3+}$, et y représentant le taux de substitution du cation trivalent thulium noté $Tm^{3+}$,

   le cation $M^{3+}$ appartenant à la famille des Lanthanides ou à la famille des Métaux de transition,
   le cation $Tm^{3+}$ présentant une structure électronique comprenant un niveau fondamental ($^3H_6$), un niveau de pompage ($^3H_4$), un niveau intermédiaire métastable (30) et une première transition (T1(Tm), T1'(Tm)) entre le niveau métastable et le niveau fondamental,
   le cation $M^{3+}$ présentant une structure électronique comprenant une première transition (T1 (M)) résonnante avec ladite première transition (T1(Tm), T1'(Tm)) du cation $Tm^{3+}$.

2. Cristal selon la revendication 1 dans lequel le niveau métastable (30) du cation $Tm^{3+}$ comprend un niveau dénommé $^3H_5$ et un niveau dénommé $^3F_4$, et dans lequel la première transition du cation $M^{3+}$ est résonnante avec la première transition du cation $Tm^{3+}$ (T1(M)) définie comme la transition entre le niveau $^3F_4$ et le niveau fondamental.

3. Cristal selon l'une des revendications précédentes dans lequel le cation $Tm^{3+}$ présente une deuxième transition (T2(Tm), T2'(Tm)) entre le niveau de pompage et le niveau métastable et dans lequel le cation $M^{3+}$ présente une structure électronique comprenant en outre une deuxième transition (T2(M)) résonnante avec ladite deuxième transition (T2(Tm), T2'(Tm)) du cation $Tm^{3+}$.

4. Cristal selon l'une des revendications 2 ou 3 dans lequel la première (T1(M)) et le cas échéant la deuxième (T2(M)) transition du cation $M^{3+}$ présente une différence d'énergie avec respectivement la première ((T1(Tm), T1'(Tm)) et le cas échéant la deuxième (T2(Tm), T2'(Tm)) transition du cation $Tm^{3+}$ d'au maximum 1500 $cm^{-1}$.

5. Cristal selon l'une des revendications précédentes dans lequel x est compris entre 0.05 et 0.9.

6. Cristal selon l'une des revendications précédentes dans lequel y est compris entre 0.001 et 0.05

7. Cristal selon l'une des revendications précédentes dans lequel le cation $M^{3+}$ est choisi parmi : l'Europium (Eu), le Terbium (Tb).

8. Dispositif (10) de traitement spectro-spatial de signaux optique par creusement spectral comprenant:

   - une source laser (L) émettant un faisceau optique,
   - un dispositif de modulation (14) configuré pour moduler le faisceau optique avec un signal à analyser,
   - un cristal (CR) selon l'une des revendications 1 à 7 disposé dans un cryostat à une température inférieure à 5K, configuré pour être illuminé par ledit faisceau optique modulé (12),
   - un détecteur (Det) configuré pour détecter au moins une fraction d'un faisceau optique issu du cristal.

9. Procédé de traitement spectro-spatial de signaux optique par creusement spectral comprenant les étapes consistant à :

   - émettre un faisceau optique,
   - moduler ledit faisceau optique par un signal à analyser,
   - illuminer un cristal disposé dans un cryostat à une température inférieure à 5K par ledit faisceau optique modulé,
   - réaliser un creusement spectral dans ledit cristal,
   - détecter au moins une fraction d'un faisceau optique issu du cristal,
   le cristal présentant la formule chimique $Y_{3(1-x-y)}Tm_{3y}M_{3x}Al_5O_{12}$ avec M représentant un cation trivalent noté $M^{3+}$ différent du thulium et choisi de sorte qu'il substitue une partie des cations trivalents yttrium notés $Y^{3+}$, x représentant le taux de substitution dudit cation $M^{3+}$, et y représentant le taux de substitution du cation trivalent thulium noté $Tm^{3+}$,
   le cation $M^{3+}$ appartenant à la famille des Lanthanides ou à la famille des métaux de transition,
   le cation $Tm^{3+}$ présentant une structure électronique comprenant un niveau fondamental ($^3H_6$), un niveau de pompage ($^3H_4$), un niveau intermédiaire métastable (30) et une première transition (T1(Tm), T1'(Tm)) entre le niveau métastable et le niveau fondamental,
   le cation $M^{3+}$ présentant une structure électronique comprenant une première transition (T1(M)) résonnante avec ladite première transition (T1 (Tm), T1'(Tm)) du cation $Tm^{3+}$.

**Patentansprüche**

1. Kristall (CR) zur Verwendung in einer Vorrichtung zur spektral-räumlichen Verarbeitung von optischen Signalen durch spektrales Lochbrennen, mit der chemischen Formel $Y_{3(1-x-y)}Tm_{3y}M_{3x}Al_5O_{12}$, wobei M ein dreiwertiges Kation mit der Bezeichnung $M^{3+}$ darstellt, das sich von Thulium unterscheidet und so ausgewählt ist, dass es einen Abschnitt der dreiwertigen Yttrium-Kationen mit der Bezeichnung $Y^{3+}$ substituiert, wobei x die Substitutionsrate des Kations $M^{3+}$ darstellt und y die Substitutionsrate des dreiwertigen Thulium-Kations mit der Bezeichnung $Tm^{3+}$ darstellt,

   wobei das Kation $M^{3+}$ zur Familie der Lanthaniden oder zur Familie der Übergangsmetalle gehört,
   wobei das Kation $Tm^{3+}$ eine elektronische Struktur aufweist, die eine Grundebene ($^3H_6$), eine Pumpebene ($^3H_4$), eine metastabile Zwischenebene (30) und einen ersten Übergang (T1(Tm), T1'(Tm)) zwischen der metastabilen Zwischenebene und der Grundebene umfasst,
   wobei das Kation $M^{3+}$ eine elektronische Struktur aufweist, die einen ersten Übergang (T1(M)) umfasst, der mit dem ersten Übergang (T1(Tm), T1'(Tm)) des Kations $Tm^{3+}$ resonant ist.

2. Kristall nach Anspruch 1, wobei die metastabile Ebene (30) des Kations $Tm^{3+}$ eine als $^3H_5$ bezeichnete Ebene und eine als $^3F_4$ bezeichnete Ebene umfasst, und wobei der erste Übergang des Kations $M^{3+}$ mit dem ersten Übergang des Kations $T^{m3+}$ (T1(M)), der als der Übergang zwischen der $^3F_4$-Ebene und der Grundebene definiert ist, resonant ist.

3. Kristall nach einem der vorhergehenden Ansprüche, wobei das Kation $Tm^{3+}$ einen zweiten Übergang (T2(Tm), T2'(Tm)) zwischen der Pumpebene und der metastabilen Ebene aufweist und wobei das Kation $M^{3+}$ eine elektronische Struktur aufweist, die zusätzlich einen zweiten Übergang (T2(M)) umfasst, der mit dem zweiten Übergang (T2(Tm), T2'(Tm)) des Kations $Tm^{3+}$ resonant ist.

4. Kristall nach einem der Ansprüche 2 oder 3, wobei der erste (T1(M)) und gegebenenfalls der zweite (T2(M)) Übergang des Kations $M^{3+}$ eine Energiedifferenz gegenüber jeweils dem ersten ((T1(Tm), T1'(Tm)) und dem zweiten (T2(Tm), T2'(Tm)) Übergang des Kations $Tm^{3+}$ von höchstens 1 500 $cm^{-1}$ aufweist.

5. Kristall nach einem der vorhergehenden Ansprüche, wobei x zwischen 0,05 und 0,9 liegt.

6. Kristall nach einem der vorhergehenden Ansprüche, wobei y zwischen 0,001 und 0,05 liegt.

7. Kristall nach einem der vorhergehenden Ansprüche, wobei das Kation $M^{3+}$ ausgewählt ist aus: Europium (Eu), Terbium (Tb).

8. Vorrichtung (10) zur spektral-räumlichen Verarbeitung von optischen Signalen durch spektrales Lochbrennen, Folgendes umfassend:

   - eine Laserquelle (L), die einen optischen Strahl aussendet,
   - eine Modulationsvorrichtung (14), die so konfiguriert ist, dass sie den optischen Strahl mit einem zu analysierenden Signal moduliert,
   - ein Kristall (CR) nach einem der Ansprüche 1 bis 7, das in einem Kryostat bei einer Temperatur unter 5K angeordnet ist und so konfiguriert ist, dass es von dem modulierten optischen Strahl (12) beleuchtet wird,
   - einen Detektor (Det), der so konfiguriert ist, dass er mindestens einen Bruchteil eines aus dem Kristall stammenden optischen Strahls erfasst.

9. Verfahren zur spektral-räumlichen Verarbeitung von optischen Signalen durch spektrales Lochbrennen, folgende Schritte umfassend:

   - Aussenden eines optischen Strahls,
   - Modulieren des optischen Strahls durch ein zu analysierendes Signal,
   - Beleuchten eines Kristalls, das in einem Kryostat bei einer Temperatur von weniger als 5K angeordnet ist, mit dem modulierten optischen Strahl,
   - Durchführen von spektralem Lochbrennen in dem Kristall,
   - Detektieren von mindestens einem Bruchteil eines aus dem Kristall stammenden optischen Strahls,
   wobei das Kristall die chemische Formel $Y_{3(1-x-y)}Tm_{3y}M_{3x}Al_5O_{12}$ aufweist, wobei M ein dreiwertiges Kation mit der Bezeichnung $M^{3+}$ darstellt, das sich von Thulium unterscheidet und so ausgewählt ist, dass es einen Abschnitt der dreiwertigen Yttrium-Kationen mit der Bezeichnung $Y^{3+}$ substituiert, wobei x die Substitutionsrate des Kations $M^{3+}$ darstellt und y die Substitutionsrate des dreiwertigen Thulium-Kations mit der Bezeichnung $Tm^{3+}$ darstellt,
   wobei das Kation $M^{3+}$ zur Familie der Lanthaniden oder zur Familie der Übergangsmetalle gehört,
   wobei das Kation $Tm^{3+}$ eine elektronische Struktur aufweist, die eine Grundebene ($^3H_6$), eine Pumpebene ($^3H_4$), eine metastabile Zwischenebene (30) und einen ersten Übergang (T1(Tm), T1'(Tm)) zwischen der metastabilen Zwischenebene und der Grundebene umfasst,
   wobei das Kation $M^{3+}$ eine elektronische Struktur aufweist, die einen ersten Übergang (T1(M)) umfasst, der mit dem ersten Übergang (T1(Tm), T1'(Tm)) des Kations $Tm^{3+}$ resonant ist.

**Claims**

1. A crystal (CR) for use in a device for spectro-spatial processing of optical signals by means of a spectral hole burning, having the chemical formula $Y_{3(i-x-y)}Tm_{3y}M_{3x}Al_5O_{12}$, with M representing a trivalent cation designated $M^{3+}$ which

is different from thulium and which is selected so that it replaces some of the trivalent yttrium cations designated $Y^{3+}$, x representing the substitution level of the cation $M^{3+}$, and y representing the substitution level of the trivalent thulium cation designated $Tm^{3+}$,

the cation $M^{3+}$ belonging to the group of lanthanides or to the group of transition metals,
the cation $Tm^{3+}$ having an electron structure which comprises a base level ($^3H_6$), a pumping level ($^3H_4$), an intermediate metastable level (30) and a first transition (T1(Tm), T1'(Tm)) between the metastable level and the base level,
the cation $M^{3+}$ having an electron structure which comprises a first transition (T1(M)) which resonates with the first transition (T1(Tm), T1,(Tm)) of the cation $Tm^{3+}$.

2. A crystal according to claim 1, wherein the metastable level (30) of the cation $Tm^{3+}$ comprises a level designated $^3H_5$ and a level designated $^3F_4$ and wherein the first transition of the cation $M^{3+}$ resonates with the first transition of the cation $Tm^{3+}$ (T1(M)) defined as the transition between the level $^3F_4$ and the base level.

3. A crystal according to either of the preceding claims, wherein the cation $Tm^{3+}$ has a second transition (T2(Tm), T2'(Tm)) between the pumping level and the metastable level and wherein the cation $M^{3+}$ has an electron structure which further comprises a second transition (T2(M)) which resonates with the second transition (T2(Tm), T2'(Tm)) of the cation $Tm^{3+}$.

4. A crystal according to any one of claims 2 or 3, wherein the first transition (T1(M)) and where necessary the second transition (T2(M)) of the cation $M^{3+}$ has a difference of energy respectively with the first transition (T1(Tm), T1'(Tm)) and the second transition (T2(Tm), T2'(Tm) of the cation $Tm^{3+}$ of a maximum of $1.500$ $cm^{-1}$.

5. A crystal according to any one of the preceding claims, wherein x is between 0.05 and 0.9.

6. A crystal according to any one of the preceding claims, wherein y is between 0.001 and 0.05.

7. A crystal according to any one of the preceding claims, wherein the cation $M^{3+}$ is selected from: europium (Eu), terbium (Tb).

8. A device (10) for spectro-spatial processing of optical signals by means of spectral hole burning, comprising:

   - a laser source (L) which transmits an optical beam,
   - a modulation device (14) which is configured to modulate the optical beam with a signal to be analysed,
   - a crystal (CR) according to any one of claims 1 to 7 which is arranged in a cryostat at a temperature less than 5K and which is configured to be illuminated by the modulated optical beam (12),
   - a detector (Det) which is configured to detect at least a fraction of an optical beam originating from the crystal.

9. A method for spectro-spatial processing of optical signals by means of spectral hole burning, comprising the steps involving:

   - transmitting an optical beam,
   - modulating the optical beam with a signal to be analysed,
   - illuminating a crystal which is arranged in a cryostat at a temperature less than 5K with the modulated optical beam,
   - carrying out a spectral hole burning in the crystal,
   - detecting at least a fraction of an optical beam originating from the crystal,
   the crystal having the chemical formula $Y_{3(1-X-y)}Tm_{3y}M_{3x}Al_5O_{12}$, with M representing a trivalent cation designated $M^{3+}$ which is different from thulium and which is selected so that it replaces some of the trivalent yttrium cations designated $Y^{3+}$, x representing the substitution level of the cation $M^{3+}$, and y representing the substitution level of the trivalent thulium cation designated $Tm^{3+}$,
   the cation $M^{3+}$ belonging to the group of lanthanides or to the group of transition metals,
   the cation $Tm^{3+}$ having an electron structure which comprises a base level ($^3H_6$), a pumping level ($^3H_4$), an intermediate metastable level (30) and a first transition (T1(Tm), T1'(Tm)) between the metastable level and the base level,
   the cation $M^{3+}$ having an electron structure which comprises a first transition (T1(M)) which resonates with the first transition (T1(Tm), T1,(Tm)) of the cation $Tm^{3+}$.

[Fig. 1a]

[Fig. 1b]

[Fig. 1c]

[Fig. 2]

[Fig. 3]

[Fig. 4]

[Fig. 5]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8829471 B

**Littérature non-brevet citée dans la description**

- **G. ARMAGAN et al.** *Optical Materials,* 1992, vol. 1, 11-20
- **A. FERRIER et al.** *J.Lumin.,* 2018, vol. 194, 116-122